# EUROPEAN PATENT APPLICATION

(11) **EP 3 342 808 A1**
(43) Date of publication of application: **04.07.2018**
(21) Application number: 17210092.7
(22) Date of filing: 22.12.2017
(51) Int. Cl.: C08J 7/04, B05D 5/08, B29C 59/14, C09D 133/16, C09D 143/04

(54) **HARD COAT FILM AND A MANUFACTURING METHOD THEREOF**

(30) Priority: 27.12.2016 JP 2016254197
(71) Applicant: Soken Chemical & Engineering Co., Ltd., Toshima-ku Tokyo 171-8531 (JP)
(72) Inventor: Meguro, Hikaru, Sayama-shi, Saitama 3501320 (JP); Takahashi, Takanori, Saitama, Saitama 350-1320 (JP)
(74) Representative: Gulde & Partner

(57) **Abstract**

A hard coat film excellent in water repellency and a manufacturing method thereof are provided. According to the present invention, there is provided a hard coat film, comprising:
a substrate;
a resin layer; and
a surface layer, wherein
the resin layer includes a (meth)acrylate resin and inorganic particles,
the surface layer is disposed on the resin layer,
a surface of the resin layer has a concave-convex shape,
at least a part of the inorganic particle is exposed on the surface of the resin layer, and
the hard coat film satisfies item (1) or (2).
(1) The resin layer includes an additive including a compound having a fluorine-containing group and/or a silicone skeleton.
(2) The (meth)acrylate resin has a site derived from the compound.

## Description

### Technical Field

The present invention relates to a hard coat film that exhibits water repellency and a manufacturing method thereof.

### Background

PTL 1 discloses a water repellent film obtained by subjecting an ultraviolet curing resin having a fine concave-convex structure to a water repellent treatment. PTL 2 discloses a PET film having a fine concave and convex structure on a surface thereof, the surface is subjected to a water repellent treatment.

### Citation List

### Patent Literature

[PTL1] Japanese Patent No.4930657
[PTL2] Japanese Patent No.3358131

### Summary of Invention

### Technical Problem

Conventionally, water repellent hard coat film produced by a photo-curing process is known. As such a hard coat film, there is known a film prepared by coating, on a substrate, a resin composition containing a photoinitiator, a multifunctional acrylate and an additive having fluorine or silicone, followed by irradiatation of light. However, a satisfactory water repellent hard coat film has not been obtained.

The present invention has been made in view of such circumstances, and is to provide a hard coat film which is excellent in water repellency and a manufacturing method thereof.

### [Solution to Problem]

According to the present invention, there is provided a hard coat film, comprising:
a substrate;
a resin layer; and
a surface layer, wherein
   the resin layer includes a (meth)acrylate resin and inorganic particles,
the surface layer is disposed on the resin layer,
a surface of the resin layer has a concave-convex shape,
at least a part of the inorganic particle is exposed on the surface of the resin layer, and
the hard coat film satisfies item (1) or (2).
   (1) The resin layer includes an additive including a compound having a fluorine-containing group and/or a silicone skeleton.
   (2) The (meth)acrylate resin has a site derived from the compound.

The present inventors have found that the above-mentioned hard coat film is excellent in water repellency to complete the prevent invention.

Various embodiments of the present invention are exemplified below. Embodiments shown below may be combined with each other.

It is preferred that, the surface layer has a surface free energy of 18 mN/m or less.

It is preferred that, the surface layer comprises a water repellent treatment layer formed by a water repellent treatment.

It is preferred that, the water repellent treatment layer comprises a silicone compound layer.

It is preferred that, the surface layer comprises an underlayer composed of a layer of inorganic or silicone compound, and the water repellent treatment layer is formed on the underlayer.

It is preferred that, the water repellent treatment layer is formed by treating the underlayer with a silane coupling agent.

It is preferred that, the additive comprises a compound having the fluorine-containing group and the silicone skeleton.

According to another aspect of the present invention, A method of manufacturing a hard coat film, comprising:
a resin composition layer forming step to form the resin composition layer by coating a photocurable resin composition on a substrate, wherein the photocurable resin composition includes (meth)acrylate, an additive, a photoinitiator, and inorganic particles; containing a compound having a fluorine-containing group and/or a silicone skeleton; a photocuring step to form a resin layer by photocuring the resin composition layer; a concave-convex shape forming step to expose at least a part of the inorganic particles on the surface of the resin layer and form a concave-convex shape on the surface of the resin layer; and a surface layer forming step to form a surface layer on the resin layer, is provided.

It is preferred that, the surface layer has a surface free energy of 18 mN/m or less.

It is preferred that, the surface layer forming step comprises a water repellent treatment step.

It is preferred that, the water repellent treatment step comprises a step of forming a silicone compound layer on the resin layer by subjecting the a resin layer a plasma treatment with vaporized silicon compound.

It is preferred that, the surface layer forming step comprises an underlayer forming step of forming the underlayer composed of an inorganic or a silicone compound on the resin layer, and the water repellent treatment step is performed after the underlayer forming step.

It is preferred that, the water repellent treatment layer is formed by treating the underlayer with a silane coupling agent.

It is preferred that, the additive comprises a compound having the fluorine-containing group and the silicone skeleton.

It is preferred that, the photocuring of the resin composition layer is performed in a state where a covering member is in close contact with the resin composition layer, and a surface of the covering member to be brought into close contact with the resin composition layer has a surface free energy of 18 mN/m or less.

### Brief Description of Drawings

Fig. 1 is a cross-sectional view illustrating a hard coat film 1 in the first embodiment of the present invention.
Figs. 2A-2E illustrate a manufacturing step of the hard coat film 1 in the first embodiment of the present invention.
Figs. 3A-3B illustrate a part of the manufacturing step of the hard coat film 1 in the second embodiment of the present invention

### Description of Embodiments

Preferred embodiments of the present invention are specifically described below with reference to the drawings.

### 1.First Embodiment

### 1-1. Hard coat film

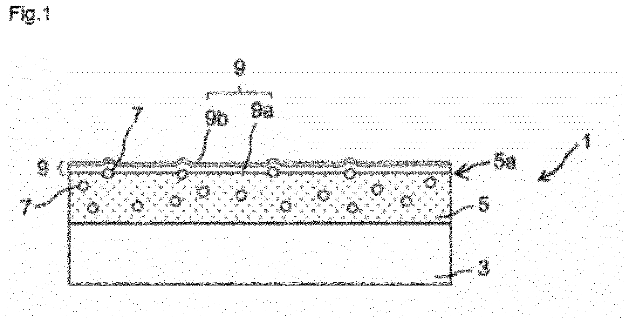

As shown in FIG. 1, the hard coat film 1 of the first embodiment of the present invention comprises a substrate 3, a resin layer 5 on at least one surface of the substrate 3, and a surface layer 9 on the resin layer 5. The resin layer 5 includes inorganic particles 7. A concave-convex shape is provided on the resin layer surface 5a, and at least a part of the inorganic particles 7 contained in the resin layer 5 is exposed on the resin layer surface 5a

The form of hard coat film 1 is not particularly limited, but it is preferably a film having flexibility and water repellency. The water contact angle of the hard coat film 1 is not particularly limited, but it is preferably 90 degrees or more, more preferably 120 degrees or more, further preferably 130 degrees or more, further preferably 150 degrees or more, further preferably 155 degrees or more. The hard coat film 1 preferably also has oil repellency.

### 1-2. Substrate

The material of the substrate 3 is not particularly limited, but it is preferably a transparent substrate such as a resin substrate, a silicone substrate, a quartz substrate or the like, and more preferably a resin substrate from the viewpoint of flexibility. Examples of the resin constituting the resin substrate include one selected from the group composed of polyethylene terephthalate, polycarbonate, polyester, polyolefin, polyimide, polysulfone, polyethersulfone, cyclic polyolefin and polyethylene naphthalate. In addition, in the case of using a resin substrate, the same or different substrates may be laminated, or the resin composition may be laminated in a film form on a resin substrate. In addition, the substrate 3 is preferably in the form of a film having flexibility, and its thickness is preferably in the range of 25 to 500 µm.

### 1-3. Resin layer

The resin layer 5 contains an additive including a compound or a site derived from the compound and inorganic particles 7 in the (meth)acrylate resin. The compound has a fluorine-containing group and/or a silicone skeleton. In addition, the surface of the resin layer 5 is formed with a concave-convex shape, and at least a part of the inorganic particle 7 is exposed on the surface of the resin layer 5.

The resin layer 5 can be formed by a method comprising a resin composition layer forming step, a photo-curing step and a concave-convex shape forming step. Each step will be described in detail below.

### <<Resin composition layer forming step>>

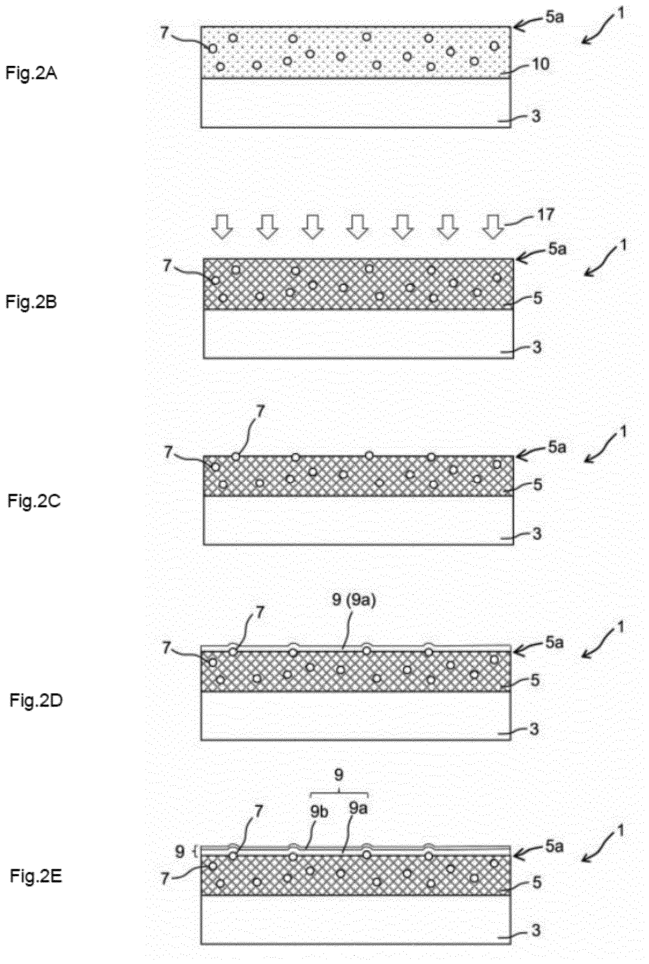

In this step, as shown in FIG. 2A, a photocurable resin composition is coated on a substrate to form a resin composition layer 10. The photocurable resin composition includes (meth)acrylate monomer, an additive including a compound having a fluorine-containing group and/or a silicone skeleton, a photoinitiator, and inorganic particles 7. The photocurable resin composition has a property of being cured by irradiation with an active energy ray 17. The "active energy ray" is a collective term for energy rays capable of curing a photocurable resin composition, such as UV light, visible light, and electron beam.

There is no particular limitation on the structure of the (meth)acrylate, monofunctional acrylates include isobornyl (meth)acrylate, 2-hydroxy-3-phenoxypropyl (meth)acrylate, isostearyl (meth)acrylate, benzyl (meth)acrylate, ethyl carbitol (meth)acrylate, phenoxyethyl (meth)acrylate, lauryl (meth)acrylate, isooctyl (meth)acrylate, tetrahydrofurfuryl (meth)acrylate, behenyl (meth)acrylate, 4-hydroxybutyl (meth)acrylate, 2-hydroxyethyl (meth)acrylate, 2-hydroxypropyl (meth)acrylate, cyclohexyl (meth)acrylate and the like. In addition, examples of the monomer of the polyfunctional acrylate include ethylene glycol di (meth)acrylate, diethylene glycol di (meth)acrylate, 1,6-hexanediol di (meth)acrylate, neopentyl glycol di(meth)acrylate, trimethylol propane tri(meth)acrylate, trimethylol ethane tri(meth)acrylate, tetramethylolmethane tri(meth)acrylate, tetramethylolmethane tetra(meth)acrylate, pentaglycerol tri(meth)acrylate, pentaerythritol di(meth)acrylate, pentaerythritol tri(meth)acrylate, pentaerythritol tetra(meth)acrylate, glycerin tri(meth)acrylate, dipentaerythritol tri(meth)acrylate, dipentaerythritol tetra(meth)acrylate, dipentaerythritol penta(meth)acrylate, dipentaerythritol hexa(meth)acrylate , tris(acryloyloxyethyl) isocyanurate and the like.

The additive includes a compound A having a fluorine-containing group and/or a silicone skeleton. The additive may be composed solely of the compound A, or it may be a mixture of the compound A and another substance. The compound A may have either one of a fluorine-containing group and a silicone skeleton, or may have both of them.

In one example, the fluorine-containing group is a perfluoroalkyl group, more specifically a perfluoroalkylsilane group. The number of carbon atoms of the perfluoroalkyl group is, for example, 1 to 10, specifically 1, 2, 3, 4, 5, 6, 7, 8, 9, 10, and may be within a range between any two of the numerical values exemplified here. In addition, the (meth) acryloyl group of the fluorine-containing compound is preferably 1 to 6 from the viewpoint of realizing water repellency of the hard coat film 1.

The compound having a fluorine-containing group is not particularly limited in structure other than having a fluorine-containing group, for example, includes a hydrocarbon group that may have a hetero atom such as an oxygen atom, a nitrogen atom, and a sulfur atom, specifically, examples include polymers such as hydrocarbon polymers and polyethers. Among these, those having a silicone skeleton in the molecule are preferable from the viewpoint of making the hard coat film 1 formed by the resin layer 5 of this embodiment excellent in water repellency.

The silicone skeleton is not particularly limited as long as it has a silicone skeleton structure in the main chain of the compound, and for example, one having an alkyl group such as a methyl group in the side chain is used. It is also preferable that the side chain, the terminal end, or both ends in the silicone molecule may be substituted with an organic group or the like. (an epoxy group, a carbinol group, a diol group, a methacryl group, a carboxyl group, a polyether group, an amino group, a mercapto group, a phenol, a silanol group, an acryl group, etc.), and a sulfonic acid group or a phosphoric acid group or a salt thereof may be introduced. In addition, a part of the silicone molecule may be fluorine-substituted.

The compound A preferably has a polymerizable unsaturated bond, and more preferably has a (meth) acryloyl group. This is because the resin layer 5 is normally formed by polymerization of (meth)acrylate, and when the compound A has a polymerizable unsaturated bond, the polymerizable monomer constituting the resin layer 5 and the compound A are copolymerized to stably hold the compound A in the resin layer 5. In the case where the compound A has a polymerizable unsaturated bond, the compound A becomes a part of a polymer constituting the resin layer 5, so that the (meth)acrylate resin in the resin layer 5 has a site derived from a compound having a fluorine-containing group and/or a silicone skeleton. On the other hand, when the compound A does not have a polymerizable unsaturated bond, the compound A does not become a part of the polymer constituting the resin layer 5 in the resin layer 5, so that the resin layer 5 has a compound having a fluorine-containing group and/or a silicone skeleton.

Examples of the additives include SUA 1900 L series (manufactured by Shin Nakamura Chemical Co., Ltd.), UT-3971 (manufactured by Nippon Synthetic Chemical Industry Co., Ltd.), Fluorosurf FS series (manufactured by FluoroTechnology Co.,Ltd.), Megaface RS series and DEFENSA TF 3000 series (manufactured by DIC Corporation), Light Procoat AFC 3000, LINC-3A (manufactured by Kyoeisha Chemical Co., Ltd.), Optool DAC- HP (Manufactured by Daikin Industries, Ltd.), KSN 5300(manufactured by Shin-Etsu Chemical Co., Ltd.), KY-1203 (manufactured by Shin-Etsu Chemical Co., Ltd.), UVHC series (Momentive Performance Materials Japan), FTERGENT 601 ADH2 (manufactured by Neos Corporation) can be used. Among them, KY-1203 (manufactured by Shin-Etsu Chemical Co., Ltd.) containing a compound having a fluorine-containing group and a silicone skeleton in the molecule is preferably used. It is because in the case where the (meth)acrylate monomer forming the resin layer 5 is polyfunctional and the additive is KY-1203 (compound having a (meth) acryloyl group), it has been experimentally clarified that the water repellency of the hard coat film 1 is improved.

The mass ratio of the additive to the photocurable resin composition is not particularly limited but is, for example, 0.005 to 0.10. Specifically, the mass ratio is, for example, 0.005, 0.01, 0.02, 0.03, 0.05, 0.07, 0.10, and may be within a range between any two of the numerical values exemplified here.

The photoinitiator is a component added to promote the polymerization of (meth)acrylate, and is preferably contained in an amount of 0.1 part by mass or more with respect to 100 parts by mass of the (meth)acrylate. The upper limit of the content of the photoinitiator is not particularly limited, but is, for example, 20 parts by mass with respect to 100 parts by mass of the (meth)acrylate.

The inorganic particle 7 is a particle of inorganic, and examples of the inorganic include a metal simple substance, an inorganic oxide film, an inorganic nitride film, an inorganic oxynitride film, and the like. Examples of the inorganic element constituting the inorganic include Si and Al. The inorganic is, for example, silicon oxide or aluminum oxide.

The average particle diameter of inorganic particle 7 is not particularly limited, but it is, for example, 5 to 400 nm. When the average particle size of inorganic particle 7 is within this range, the water repellency tends to be high. The average particle diameter of inorganic particle 7 is, for example, 5, 10, 15, 20, 25, 50, 100, 150, 200, 250, 300, 350, 400 nm, may be within a range between any two of the numerical values exemplified here. Here, the average particle diameter in the present invention means the diameter (D50) at which the larger side and the smaller side are equal when the powder is divided into two from a certain particle diameter, and the average particle diameter of inorganic particle 7 means values obtained by dynamic light scattering method.

The mass ratio of inorganic particle 7 to the photocurable resin composition is not particularly limited but is, for example, 0.01 to 0.5. Specifically, this mass ratio is, for example, 0.01, 0.02, 0.03, 0.05, 0.1, 0.15, 0.2, 0.25, 0.3, 0.35, 0.4, 0.45, 0.5, and may be within a range between any two of the numerical values exemplified here.

The photocurable resin composition may contain components such as a solvent, a polymerization inhibitor, a chain transfer agent, an antioxidant, a photosensitizer, a filler, a leveling agent, etc. within a range that does not affect the properties of the photocurable resin composition.

The photocurable resin composition can be produced by mixing the above components by a known method. The photocurable resin composition can be coated on the substrate 3 by a method such as spin coating, spray coating, bar coating, dip coating, die coating and slit coating to form a resin composition layer 10.

Although the thickness of the resin composition layer 10 is not particularly limited, it is preferably such a thickness that a resin composition can be coated to a uniform thickness, for example, is 20 nm to 1 mm and preferably from 50 nm to 500 µm, and more preferably from 100 nm to 200 µm, even more preferably from 500 nm to 50 µm.

### <<Photocuring step>>

In this step, resin layer 5 is formed by photocuring the resin composition layer 10 as shown in FIG. 2B.

The resin composition layer 10 can be photo-curing by irradiating the resin composition layer 10 with the active energy ray 17 from the side of the resin composition layer 10 or from the side of the substrate 3. The resin layer 5 may be irradiated with the active energy ray 17 in an amount of the integral light to sufficiently cure the resin composition layer 10, and the integral light amount is, for example, 100 to 10000 mJ/cm². By irradiation with the active energy ray 17, the resin composition layer 10 is cured. In the present embodiment, irradiation of active energy rays 17 is performed from the side of the resin composition layer 10, but irradiation of active energy ray 17 may be performed from the substrate side.

### <<Concave-convex shape forming step>>

In this step, as shown in FIG. 2C, at least a part of the inorganic particle 7 is exposed from the surface of the resin layer 5 and a concave-convex shape is formed on the surface of the resin layer 5.

In this step, for example, the resin layer 5 can be shaped by etching to obtain a desired concave-convex shape. The etching method is not particularly limited, and may be wet etching or dry etching, which can be appropriately selected to obtain a desired shape. An example of dry etching is oxygen plasma ashing. When the etching process is performed on the resin layer 5, the resin layer 5 retreats. On the other hand, since the etching rate of the inorganic particle 7 included in the resin layer 5 is smaller than that of the resin, the resin layer 5 is hard to be retreated at the portion where the inorganic particle 7 is exposed. Therefore, when the etching process of the resin layer 5 is performed, the inorganic particle 7 functions as an etching mask so that at least a part of the inorganic particle 7 is exposed from the surface of the resin layer 5 and a concave-convex shape is formed on the surface of the resin layer 5. Further, since the inorganic particle 7 is randomly arranged in the resin layer 5, a random concave-convex shape is formed on the surface of the resin layer 5.

The average height of the concave-convex shape is not particularly limited, but is, for example, 15 nm or more. It is 15 nm to 100 µm, and preferably from 50 nm to 10 µm

### 1-4. Surface layer

In the present embodiment, the surface layer 9 is provided on the resin layer 5. The surface layer 9 preferably has a surface free energy of 18 mN/m or less. The surface layer 9 preferably includes a water repellent treatment layer 9b formed by a water repellent treatment. Here, the water repellent treatment is not particularly limited as long as it is a treatment that can increase the water repellency of the hard coat film. The water repellent treatment layer 9b is a silicone compound layer or a fluorine-containing layer. The silicone compound layer is preferably formed on the resin layer 5. The fluorine-containing layer is preferably formed on the base layer 9a.

The silicone compound layer can be formed on the resin layer 5 by, for example, plasma-treating the silicon compound in a vaporized state to polymerize the silicon compound. The silicon compound is not particularly limited as long as it becomes gaseous at the time of plasma treatment. For example, a silane compound, a siloxane compound, a silazane compound, or the like can be used. Examples of silane compounds include dimethyldisilane, trimethyldisilane, tetramethyldisilane, pentamethyldisilane, hexamethyldisilane and the like. Examples of siloxane compounds include dimethyldisiloxane, trimethyldisiloxane, tetramethyldisiloxane, pentamethyldisiloxane, hexamethyldisiloxane, trimethylcyclotrisiloxane, tetramethylcyclotrisiloxane, pentamethylcyclotrisiloxane, hexamethylcyclotrisiloxane, octamethylcyclotetrasiloxane and the like. In addition, examples of silazane compounds include dimethyldisilazane, trimethyldisilazane, tetramethyldisilazane, pentamethyldisilazane, hexamethyldisilazane, and the like. These silicon compounds may be used singly or in combination of two or more. Examples of the silicone compound include various silicone compounds (substituted silicone, modified silicone, etc.) such as polydimethylsiloxane. It is preferred that the silicon-containing polymer is more isotopically polydimethylsiloxane.

In the case where the surface layer 9 includes the base layer 9a and the water repellent treatment layer 9b, in one example, the surface layer 9 can be formed by a method including an underlayer forming step and a water repellent treatment step. Each step will be described in detail below.

### <<Underlayer forming step>>

In this step, as shown in FIG. 2D, an underlayer composed of a layer of inorganic or silicone compound is formed so as to cover the resin layer surface 5a. Examples of the underlayer include an inorganic oxide film, an inorganic nitride film, an inorganic oxynitride film, and the like. Examples of the inorganic element constituting the underlayer include silicon and aluminum. The underlayer is, for example, a silicon dioxide film or an aluminum oxide film. Examples of the silicone compound include various silicone compounds (substituted silicone, modified silicone, etc.) such as polydimethylsiloxane. It is preferably a silicon-containing polymer and more preferably a polydimethylsiloxane. When the underlayer 9a is composed of an inorganic substance, the underlayer 9a can be formed by a method such as vapor deposition or sputtering. When the underlayer 9a is made of a silicone compound, the underlayer 9a can be formed by irradiating the silicone compound with plasma to form a polymerized film. The underlayer 9a may be formed so as to cover at least a part of the concave-convex shape formed on the resin layer surface 5a. The thickness of the underlayer 9a is not particularly limited, but is, for example, 1 to 20 nm.

### <<Water repellent treatment step>>

In this step, as shown in FIG. 2E, the underlayer 9 a is surface-treated to form a water repellent treatment layer 9b. The water repellent treatment layer 9b is composed of, for example, a fluorine-containing layer. By doing so, it is possible to increase the water repellency of the hard coat film 1. The fluorine-containing layer may contain a fluorine atom, and its thickness and composition are not limited. The fluorine-containing layer preferably contains a fluorine-containing group containing a fluorine atom. In one example, the fluorine-containing group is a perfluoroalkyl group, more specifically a perfluoroalkylsilane group. The fluorine atom-containing group is preferably chemically bonded to the resin of the resin layer 5, the inorganic particles 7 exposed on the surface of the resin layer 5, or the underlayer 9a. Generally, fluorine-containing groups are likely to form strong chemical bonds to underlayer 9a, so by providing an underlayer 9a between the resin layer 5 and the fluorine-containing layer, the fluorine-containing layer is strongly held on the resin layer 5.

As an example, the water repellent treatment layer 9b is formed so as to cover the underlayer 9a by reacting the underlayer 9a with a silane coupling agent. As the silane coupling agent, a fluorine-containing silane coupling agent containing a fluorine atom is preferable, for example, a perfluoroalkyltrialkoxy (methoxy, ethoxy, etc.) silane. Commercially available products of the silane coupling agent include OPTOOL DSX Manufactured by DAIKIN Co., Ltd..

The water repellent treatment layer 9b may be formed so as to cover at least a part of the underlayer 9a.

Even if a silane coupling agent is acted on the resin of resin layer 5 without forming the underlayer 9a, it is difficult to form a strong chemical bond, so it is preferable to form the underlayer 9a on resin layer 5 beforehand. However, in the case where the resin contained in the resin layer 5 tends to form a chemical bond with the silane coupling agent, the underlayer 9a is not necessary.

As an example, by performing the treatment as described above, it is possible to make the surface free energy of the surface layer 9 low. By doing so, the water contact angle of hard coat film 1 can be made large. That is, it is possible to increase the water repellency of the hard coat film 1. From the viewpoint of water repellency, the surface free energy of the surface layer 9 may be low, preferably 18 mN/m or less, more preferably 15 mN/m or less, further preferably 10 mN/m or less, and even more preferably 5 mN/m or less.

### 2. Second embodiment

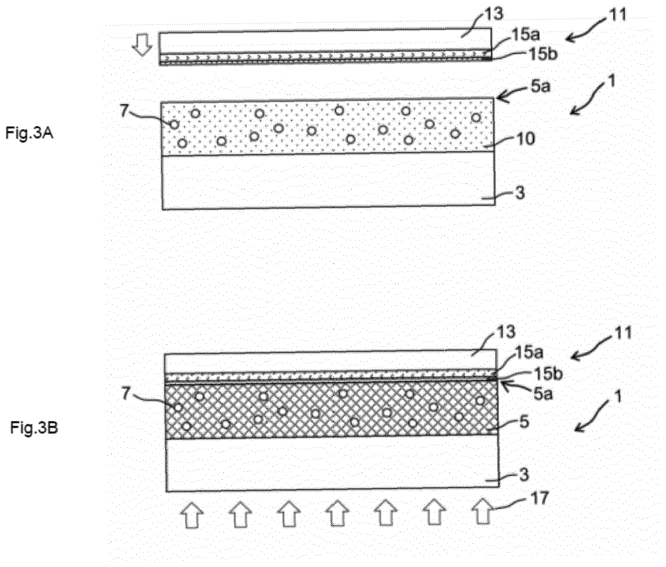

With reference to FIG. 3, the hard coat film 1 of the second embodiment of the present invention will be described. The hard coat film 1 of this embodiment is similar to the first embodiment, but in the present embodiment, as shown in FIGS. 3A to 3B, the difference is that the resin composition layer 10 is photocured in a state where the covering member 11 is in close contact with the resin composition layer 10.

The kind of the covering member 11 is not particularly limited, for example, those made of resin or made of nickel can be used. The pressure for pressing the covering member 11 against the resin layer 5 is not particularly limited as long as the surface of the covering member 11 can keep the state in contact with the resin layer 5. It is preferred that, the covering member 11 has a surface free energy of 18 mN/m or less. It was experimentally clarified that the water repellency of hard coat film 1 improves by performing photo-curing of resin composition layer 10 with covering member 11 having low surface free energy closely contacted. From the viewpoint of water repellency, the surface free energy of the covering member 11 may be low, preferably 15 mN/m or less, further preferably 10 mN/m or less, even more preferably 5 mN/m or less.

The covering member 11 can be formed in one example by forming a surface layer 15 on the substrate 13 as shown in FIG. 3A. The surface layer 15 preferably has the water repellent treatment layer 15b on the underlayer 15a. Explanation of the substrate 13, the surface layer 15, the underlayer 15 a, and the water repellent treatment layer 15b are the same as that of the substrate 3, the surface layer 9, the underlayer 9a, and the water repellent treatment layer 9b.

### EXAMPLES

Examples and Comparative Examples of the present invention are shown below.

### <<Preparation of photocurable resin composition>>

First, a photocurable resin composition was prepared by blending (meth)acrylate, a crosslinking agent, an additive, an inorganic particle, and a photoinitiator at the ratios shown below. Table 1 shows those listed for each formulation.

**[Table 1]**

| Table 1 | | Formulation 1 | Formulation 2 | Formulation 3 | Formulation 4 |
|---|---|---|---|---|---|
| Ingredients | | | | | |
| (Meth) acrylate | Dipentaerythritol polyacrylate | 87 | 87 | 87 | 87 |
| Crosslinking agent | HDI | 13 | 13 | 13 | 13 |
| Additive | KY-1203 | 4.4 | 4.4 | 0 | 4.4 |
| Inorganic particle | ALMIBK15wt%-M21 | 33 | 17 | 33 | 0 |
| Photoinitiator | Irgacure 184 | 3 | 3 | 3 | 3 |
| Solvent | MIBK | 67 | 67 | 67 | 67 |

### <<Ingredients >>

Dipentaerythritol polyacrylate : NK Ester A-9570 W manufactured by Shin-Nakamura Chemical Co., Ltd.
HDI (hexamethylene diisocyanate): HDI manufactured by Tosoh Corporation
KY-1203 (terminal (meth) acrylic modified perfluoropolyether): manufactured by Shin-Etsu Chemical Co., Ltd.
ALMIBK 15 wt% - M21 (nanosilica toluene dispersion [solid content 15 wt%] (D 50: 13 nm)): manufactured by CIK Nanotech
Irgacure 184: manufactured by BASF Japan
MIBK (methyl isobutyl ketone)

### <<Examples and Comparative Examples>>

### [Example 1]

The ingredients shown in the above Formulation 1 were blended and mixed by stirring to obtain a photocurable resin composition. On the other hand, a covering member was obtained by forming an underlayer in a thickness of 10 nm on a PET substrate by vacuum evaporation of SiO₂, and treating the surface of the underlayer with perfluoroalkoxysilane to form a water repellent treatment layer. The surface free energy of the covering member was calculated by the method described later and it was 14 mN/m. Using this photocurable resin composition and covering member, a hard coat film was prepared by the following method.

### <<Resin composition layer forming step>>

First, the resin composition layer was formed by bar coating the above photocurable resin composition in a thickness of 5 µm on an easy adhesion treatment PET substrate and then heat-treated at 110 °C (in dry state) for 5 minutes.

### <<Photocuring step>>

Next, the resin composition layer was photocured by performing UV irradiation with the covering member in close contact with the resin composition layer, and thereafter the covering member was released to form a resin layer in which the resin composition layer was photocured.

### <<Concave-convex shape forming step>>

Next, the resin layer obtained by photocuring was subjected to a treatment for 300 seconds at a high frequency (13.56 MHz) with an output of 200 W under a vacuum of 50 [Pa] or less by an oxygen plasma apparatus manufactured by SAMCO, to form a random concave-convex shape on the resin layer. At this point, part of the inorganic particles was exposed on the surface of the resin layer, and the part where the inorganic particles were exposed was convex.

### <<Surface layer forming step>>

Subsequently, SiO2 was deposited in a thickness of 10 nm on the resin layer having a random concave-convex shape on the surface by vacuum evaporation to form an underlayer, and the surface of the underlayer was treated with a fluorine-containing silane coupling agent (perfluoroalkoxysilane) to form a water repellent treatment layer (fluorine-containing layer).

### [Example 2]

A hard coat film was prepared in the same manner as in Example 1 except that the photocurable resin composition was prepared with Formulation 2 (case where the blending amount of inorganic particle was changed) of Table 1.

### [Example 3]

A hard coat film was prepared in the same manner as in Example 1 except that no covering member was used.

### [Comparative Example 1]

A hard coat film was prepared in the same manner as in Example 1 except that the photocurable resin composition was prepared with Formulation 3 (case where no additive was added) of Table 1.

### [Comparative Example 2]

A hard coat film was prepared in the same manner as in Example 1, except that the photocurable resin composition was prepared in Formulation 4 (case where the inorganic particle was not blended) of Table 1.

### [Comparative Example 3]

A hard coat film was prepared in the same manner as in Example 1 except that the oxygen plasma treatment was not performed on the surface of the resin layer.

### [Comparative Example 4]

A hard coat film was prepared in the same manner as in Example 1 except that the surface of the resin layer was not treated with perfluoroalkoxysilane.

### <Measurement of average surface roughness>

The average surface roughness is a numerical value obtained from an image obtained by DFM mode observation of a scanning probe microscope (manufactured by SII NanoTechnology Inc.) using a scanning probe microscope PC software "Spisel 32".

### <Measurement of surface area ratio>

The surface area ratio is a numerical value obtained from an image obtained by DFM mode observation of a scanning probe microscope (manufactured by SII NanoTechnology Inc.) using a scanning probe microscope PC software "Spisel 32".

### <Measurement of water contact angle>

Water contact angle was measured with respect to the obtained water repellent film, using a contact angle measuring device (DSA 25S, manufactured by KRUSS GmbH) by adding 5 to 8 µl of ion-exchanged water dropwise to the surface of the film at room temperature (25 °C) and measuring the contact angle between the film and water.

### < Surface free energy>

The surface free energy was calculated by Owens-Wendt theory from the measured values obtained by changing the ion exchange water to diiodomethane, and measuring the contact angle in the same manner as above.

The production conditions and measurement results in the Examples and Comparative Examples are shown in Table 2.

**[Table 2]**

| | | Example | | | Comparative Example | | | |
|---|---|---|---|---|---|---|---|---|
| Table 2 | | 1 | 2 | 3 | 1 | 2 | 3 | 4 |
| Formulation | | 1 | 2 | 1 | 3 | 4 | 1 | 1 |
| Production conditions | Presence / absence of covering member | Presence | Presence | Absence | Presence | Presence | Presence | Presence |
| | Presence / absence of concave-convex shape forming step | Presence | Presence | Presence | Presence | Presence | Absence | Presence |
| | Presence / absence of surface layer forming step | Presence | Presence | Presence | Presence | Presence | Presence | Absence |
| Measurement results | Average surface roughness[ n m] | 80 | 70 | 37 | 40 | 12 | 10 | 40 |
| | Surface area ratio | 1.34 | 1.26 | 1.26 | 1.15 | 1.07 | 1.05 | 1.20 |
| | Water contact angle [degree] | 156 | 156 | 130 | 130 | 90 | 88 | 45 |
| | Surface free energy [mN/m] | 0.8 | 0.8 | 18 | 55 | 22 | 37 | 59 |

As shown in Table 2, in Examples 1 to 3, it was found that the water contact angle was large and the water repellency was excellent. Further, it was found that in Examples 1 and 2 where photocuring was performed in a state where the covering member was closely contacted, the water contact angle of the hard coat film was further increased, and very excellent water repellency was exhibited.

In Comparative Examples 1 and 2, the production conditions were the same as in Examples 1 and 2, but it was found that the water repellency greatly decreased due to not containing additives or inorganic particles in the photocurable resin composition. Further, in Comparative Example 3, it was found that water repellency was greatly decreased by not forming concave-convex shape in the resin layer. In Comparative Example 4, it was also found that the water repellency was further greatly decreased by not forming the water repellent treatment layer.

### Reference Signs List

1 : Hard coat film
3 : Substrate
5 : Resin layer
5a : Resin layer surface
7 : Inorganic particle
9 : Surface layer
9a : Underlayer
9b : Water repellent treatment layer
10 : Resin composition layer
11 : Covering member
13 : Covering member substrate
15 : Surface layer
15a : Covering member underlayer
15b : Covering member water repellent treatment layer
17 : Active energy ray

## Claims

1. A hard coat film, comprising:
a substrate;
a resin layer; and
a surface layer, wherein
the resin layer includes a (meth)acrylate resin and inorganic particles,
the surface layer is disposed on the resin layer,
a surface of the resin layer has a concave-convex shape,
at least a part of the inorganic particle is exposed on the surface of the resin layer, and
the hard coat film satisfies item (1) or (2).
(1) The resin layer includes an additive including a compound having a fluorine-containing group and/or a silicone skeleton.
(2) The (meth)acrylate resin has a site derived from the compound.

2. The hard coat film according to Claim 1, wherein the surface layer has a surface free energy of 18 mN/m or less.

3. The hard coat film according to Claim 1 or 2, wherein the surface layer comprises a water repellent treatment layer formed by a water repellent treatment.

4. The hard coat film according to Claim 3, wherein the water repellent treatment layer comprises a silicone compound layer.

5. The hard coat film according to Claim 1 or 2, wherein the surface layer comprises an underlayer composed of a layer of inorganic or silicone compound, and
the water repellent treatment layer is formed on the underlayer.

6. The hard coat film according to Claim 5, wherein the water repellent treatment layer is formed by treating the underlayer with a silane coupling agent.

7. The hard coat film according to any one of Claims 1 to 6, wherein the additive comprises a compound having the fluorine-containing group and the silicone skeleton.

8. A method of manufacturing a hard coat film, comprising:
a resin composition layer forming step to form the resin composition layer by coating a photocurable resin composition on a substrate, wherein the photocurable resin composition includes a (meth)acrylate, an additive, a photoinitiator, and inorganic particles, the additive containing a compound having a fluorine-containing group and/or a silicone skeleton;
a photocuring step to form a resin layer by photocuring the resin composition layer;
a concave-convex shape forming step to expose at least a part of the inorganic particles on a surface of the resin layer and form a concave-convex shape on the surface of the resin layer; and
a surface layer forming step to form a surface layer on the resin layer.

9. The method according to Claim 8, wherein the surface layer has a surface free energy of 18 mN/m or less.

10. The method according to Claim 8 or 9, wherein the surface layer forming step includes a water repellent treatment step.

11. The method according to Claim 10, wherein the water repellent treatment step comprises a step of forming a silicone compound layer on the resin layer by subjecting the resin layer a plasma treatment with a vaporized silicon compound.

12. The method according to Claim 10, wherein the surface layer forming step comprises an underlayer forming step of forming the underlayer composed of an inorganic compound or a silicone compound on the resin layer, and
the water repellency treatment step is performed after the underlayer forming step.

13. The method according to Claim 12, wherein the water repellent treatment layer is formed by treating the underlayer with a silane coupling agent.

14. The method according to any one of Claims 8 to 13, wherein the additive comprises a compound having the fluorine-containing group and the silicone skeleton.

15. The method according to any one of Claims 8 to 14, wherein the photocuring of the resin composition layer is performed in a state where a covering member is in close contact with the resin composition layer, and
a surface of the covering member to be brought into close contact with the resin composition layer has a surface free energy of 18 mN/m or less.
